# EUROPEAN PATENT SPECIFICATION

(11) **EP 3 035 397 B1**
(45) Date of publication and mention of the grant of the patent: **11.04.2018**
(21) Application number: 14848730.9
(22) Date of filing: 24.09.2014
(51) Int. Cl.: H01L 35/30, C09J 7/02, C09J 183/04, C09J 201/00, H01L 35/32, H01L 35/34, H02N 11/00, H01L 35/02, C09J 9/02, C08K 3/38, C08K 3/22, C08K 3/04

(54) **HEAT-CONDUCTIVE ADHESIVE SHEET, MANUFACTURING METHOD FOR SAME, AND ELECTRONIC DEVICE USING SAME**
WÄRMELEITENDE KLEBEFOLIE, HERSTELLUNGSVERFAHREN DAFÜR UND ELEKTRONISCHE VORRICHTUNG DAMIT
FEUILLE ADHÉSIVE THERMOCONDUCTRICE, PROCÉDÉ DE FABRICATION DE CETTE DERNIÈRE ET DISPOSITIF ÉLECTRONIQUE UTILISANT CETTE DERNIÈRE

(30) Priority: 25.09.2013 JP 2013198771
(43) Date of publication of application: 22.06.2016
(73) Proprietor: Lintec Corporation, Tokyo 173-0001 (JP)
(72) Inventor: KATO, Kunihisa, Tokyo 173-0001 (JP); MORITA, Wataru, Tokyo 173-0001 (JP); MUTOU, Tsuyoshi, Tokyo 173-0001 (JP)
(74) Representative: Gille Hrabal
(86) International application number: PCT/JP2014/075298
(87) International publication number: WO 2015/046253

(56) References cited:
- JP-A- H0 870 142
- JP-A- 2008 182 160
- JP-A- 2009 088 117
- JP-A- 2009 302 168

## Description

### Technical Field

The present invention relates to a thermally conductive adhesive sheet and particularly to a thermally conductive adhesive sheet used in an electronic device, a method for producing the same, and an electronic device using the same.

### Background Art

Conventionally, a sheet-shaped heat-dissipating member having high thermal conductivity is used inside an electronic device or the like in order to release heat or control the flow of heat in a particular direction. Examples of the electronic device include thermoelectric conversion devices, photoelectric conversion devices, and semiconductor devices such as large scale integrated circuits.

Nowadays, in semiconductor devices, as the miniaturization and densification of the semiconductor devices, and the like proceed, the temperature of heat generated from the inside during operation becomes higher, and when heat dissipation is not sufficient, the properties of the semiconductor devices themselves decrease to sometimes cause malfunction, which may finally lead to the breakage or life decrease of the semiconductor devices. In such a case, as a means to efficiently dissipate, to the outside, heat generated from the semiconductor device, a heat-dissipating sheet having excellent thermal conductivity is provided between the semiconductor device and a heat sink (metal member).

In addition, in thermoelectric conversion devices among such electronic devices, studies of selectively controlling heat dissipation in a particular direction (efficiently providing a temperature difference to the inside of a thermoelectric element) using a sheet-shaped heat-dissipating member, which relate to the control of heat dissipation described above, have been made; because the obtained power increases when heat provided to one face of a thermoelectric element is controlled so that the temperature difference increases in the thickness direction inside the thermoelectric element. Patent Literature 1 discloses a thermoelectric conversion element having a structure as shown in Fig. 7. Specifically, a P-type thermoelectric element 41 and an N-type thermoelectric element 42 are connected in series; thermoelectromotive force extraction electrodes 43 are arranged at both ends thereof to constitute a thermoelectric conversion module 46; and film-shaped substrates 44 and 45 having flexibility composed of two types of materials having different thermal conductivities are provided on both faces of the thermoelectric conversion module 46. In the film-shaped substrates 44 and 45, materials having low thermal conductivity (polyimide) 47 and 48 are provided on the sides of the joining faces to the above thermoelectric conversion module 46, and materials having high thermal conductivity (copper) 49 and 50 are provided on the sides opposite to the joining faces of the above thermoelectric conversion module 46 so as to be positioned in portions of the outer faces of the film-shaped substrates 44 and 45. Patent Literature 2 discloses a thermoelectric conversion module having a structure shown in Fig. 8. Electrodes 54 also serving as high thermal conductivity members are embedded in low thermal conductivity members 51 and 52, and they are arranged on a thermoelectric element 53 via an electrically conductive adhesive layer 55 and an insulating adhesive layer 56

JP2008182160 A describes a flexible thermoelectric conversion element which has a pattern layer composed of a resin layer and a metal layer on both faces of a thermoelectric conversion module. The resin layer and the metal layer are formed on an insulating base-layer in accordance with each position where each element material of module materials faces each other.

### Citation List

### Patent Literature

PTL1: JP 3981738 B
PTL2: JP 2011-35203 A

### Summary of Invention

### Technical Problem

As described above, particularly, in electronic devices mainly including semiconductor devices, there is a need for a heat-dissipating sheet that can more efficiently dissipate heat to the outside, and a thermally conductive sheet or the like having excellent thermal conductivity and further having the function of selectively dissipating heat in a particular direction to produce a temperature gradient inside the electronic device.

In view of the above problem, it is an object of the present invention to provide a thermally conductive adhesive sheet that can be laminated on an electronic device to efficiently dissipate heat and to selectively dissipate heat in a particular direction to provide a sufficient temperature difference to the inside of the electronic device, a method for producing the same, and an electronic device using the same.

### Solution to Problem

The present inventors have studied diligently in order to solve the above object, and as a result found that the above object is solved by making a thermally conductive adhesive sheet having the following configuration: the thermally conductive sheet comprises a base material comprising a high thermally conductive portion and a low thermally conductive portion, and an adhesive layer laminated on one face of the base material; and the other face of the base material is composed of the face of the low thermally conductive portion opposite to the face in contact with the adhesive layer and the face of the high thermally conductive portion opposite to the face in contact with the adhesive layer, or at least either the high thermally conductive portion or the low thermally conductive portion constitutes a portion of the thickness of the base material, thereby completing the present invention.

Specifically, the present invention provides a thermally conductive adhesive sheet according to the claims.

### Advantageous Effects of Invention

The thermally conductive adhesive sheet of the present invention can be laminated on an electronic device to efficiently diffuse heat and to selectively dissipate heat in a particular direction to provide a sufficient temperature difference to the inside of the electronic device. The thermally conductive adhesive sheet of the present invention can release heat, or selectively control the flow of heat in a particular direction, inside an electronic device or the like, and therefore particularly when it is used in a thermoelectric conversion device, a temperature difference can be efficiently provided to the thermoelectric elements, and therefore power generation with high power generation efficiency is possible.

### Brief Description of Drawings

[Fig. 1] Fig. 1 is a perspective view showing one example of the thermally conductive adhesive sheet of the present invention.
[Fig. 2] Fig. 2 shows cross-sectional views showing various examples of the thermally conductive adhesive sheets of the present invention.
[Fig. 3] Fig. 3 is a cross-sectional view showing one example of a thermoelectric conversion device when the thermally conductive adhesive sheets of the present invention are affixed to a thermoelectric conversion module.

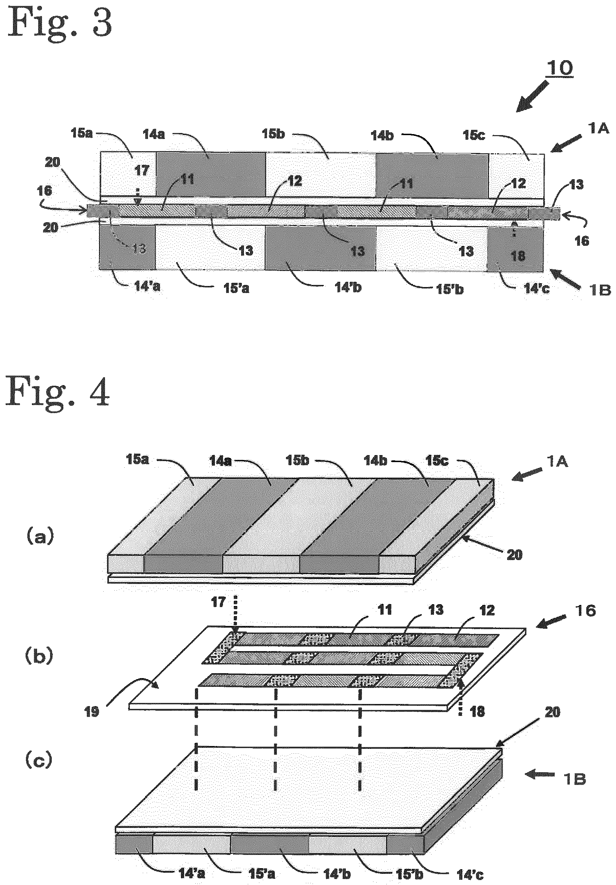

[Fig. 4] Fig. 4 shows one example of a perspective view in which the thermally conductive adhesive sheets of the present invention and a thermoelectric conversion module are disassembled for each component, and (a) is a perspective view of the thermally conductive adhesive sheet directly provided on thermoelectric elements on the front face side of the support of the thermoelectric conversion module, (b) is a perspective view of the thermoelectric conversion module, and (c) is a perspective view of the thermally conductive adhesive sheet provided on the back face side of the support of the thermoelectric conversion module.
[Fig. 5] Fig. 5 shows explanatory diagrams of a configuration for measuring the temperature difference between the high thermally conductive portions and low thermally conductive portions of the thermally conductive adhesive sheet of the present invention, and (a) shows the thermally conductive adhesive sheet, and (b) is a perspective view of a glass substrate used as an adherend.
[Fig. 6] Fig. 6 is a perspective view of a thermoelectric conversion module used in Examples of the present invention.

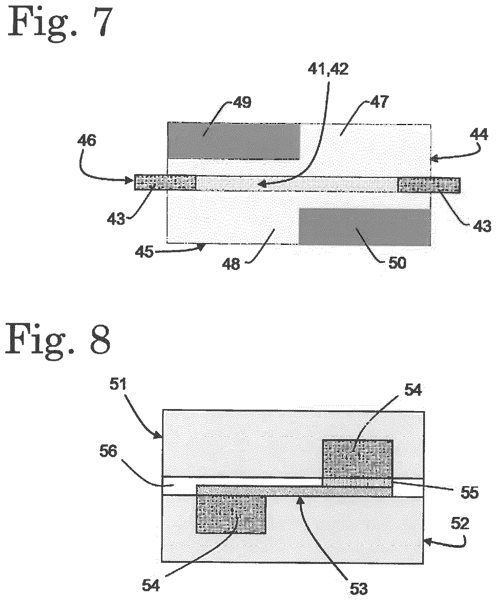

[Fig. 7] Fig. 7 is a cross-sectional view showing one example of the configuration of a conventional thermoelectric conversion device.
[Fig. 8] Fig. 8 is a cross-sectional view showing another example of the configuration of a conventional thermoelectric conversion device.

### Description of Embodiments

### [Thermally Conductive Adhesive Sheet]

The thermally conductive adhesive sheet of the present invention is a thermally conductive adhesive sheet comprising: a base material comprising a high thermally conductive portion and a low thermally conductive portion, and an adhesive layer, wherein the adhesive layer is laminated on one face of the base material; and the other face of the base material is composed of the face of the low thermally conductive portion opposite to the face in contact with the adhesive layer and the face of the high thermally conductive portion opposite to the face in contact with the adhesive layer, or at least either the high thermally conductive portion or the low thermally conductive portion constitutes a portion of the thickness of the base material.

The thermally conductive adhesive sheet of the present invention is composed of a base material and an adhesive layer. The configuration of the thermally conductive adhesive sheet of the present invention, and the like will be described using the drawings.

### <Base Material>

The base material is composed of a high thermally conductive portion and a low thermally conductive portion having different thermal conductivities from each other.

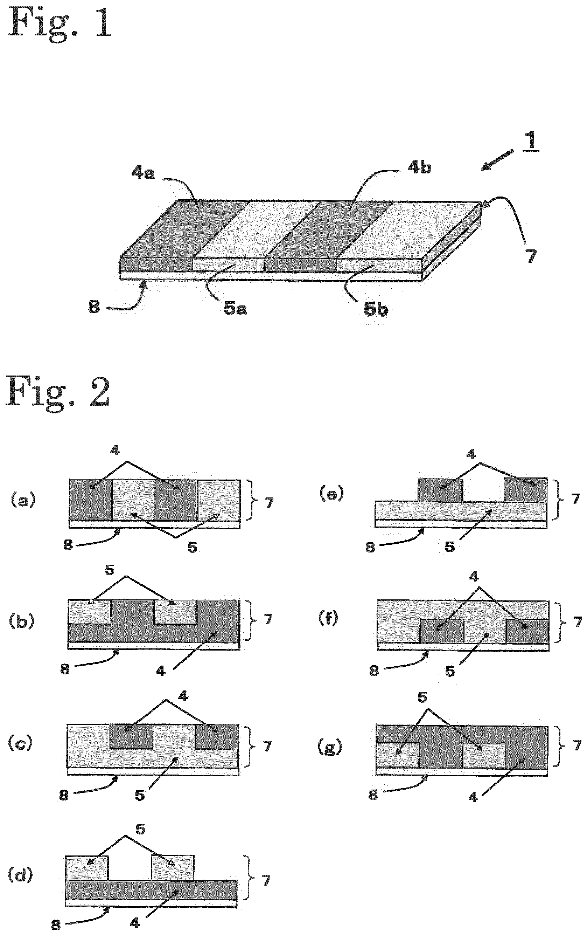

Fig. 1 shows one example of a perspective view of the thermally conductive adhesive sheet of the present invention. A thermally conductive adhesive sheet 1 is composed of a base material 7 comprising high thermally conductive portions 4a and 4b and low thermally conductive portions 5a and 5b, and an adhesive layer 8, and the high thermally conductive portions and the low thermally conductive portions are alternately arranged. In other words, the adhesive layer 8 is laminated on one face of the base material 7, and the other face of the base material 7 is composed of the faces of the low thermally conductive portions 5a and 5b opposite to the faces in contact with the adhesive layer 8 and the faces of the high thermally conductive portions 4a and 4b opposite to the faces in contact with the adhesive layer 8.

The arrangement of the high thermally conductive portions and the low thermally conductive portions constituting the base material 7 of the thermally conductive adhesive sheet 1 (hereinafter sometimes referred to as the configuration of thickness) is not particularly limited as described below.

Fig. 2 shows various examples of cross-sectional views (including arrangement) of the thermally conductive adhesive sheets of the present invention. The (a) of Fig. 2 is a cross-sectional view of Fig. 1, and the high thermally conductive portions 4 and the low thermally conductive portions 5 each independently constitute the entire thickness of the base material 7. In addition, in the (b) to (g) of Fig. 2, at least either the high thermally conductive portions 4 or the low thermally conductive portions 5 constitute a portion of the thickness of the base material. Specifically, in the (b) and (d) of Fig. 2, the low thermally conductive portions 5 constitute a portion of the thickness of the base material 7, and the face of the base material 7 in contact with the adhesive layer 8 is formed of only the high thermally conductive portion 4. Further, in the (c) and (e) of Fig. 2, the high thermally conductive portions 4 constitute a portion of the thickness of the base material 7, and the face of the base material 7 in contact with the adhesive layer 8 is formed of only the low thermally conductive portion 5. In the (f) of Fig. 2, the high thermally conductive portions 4 constitute a portion of the thickness of the base material 7; the face of the base material 7 in contact with the adhesive layer 8 is formed of both the high thermally conductive portions 4 and the low thermally conductive portion 5; and the face of the base material 7 opposite to the face in contact with the adhesive layer 8 is formed of only the low thermally conductive portion 5. In the (g) of Fig. 2, the low thermally conductive portions 5 constitute a portion of the thickness of the base material 7; the face of the base material 7 in contact with the adhesive layer 8 is formed of both the high thermally conductive portion 4 and the low thermally conductive portions 5; and the face of the base material 7 opposite to the face in contact with the adhesive layer 8 is formed of only the high thermally conductive portion 4. The configuration of the thickness of the base material 7 can be appropriately selected in accordance with the specifications of an applied electronic device. For example, from the viewpoint of selectively dissipating heat in a particular direction, for example, the configurations of thickness in the (a) to (g) of Fig. 2 are preferably selected, and the configuration in which the high thermally conductive portions and the low thermally conductive portions each independently constitute the entire thickness of the base material, that is, the configuration of thickness in the (a), is further preferred. In addition, from the viewpoint of efficiently dissipating, to the outside, heat generated from the inside of an electronic device, for example, the configurations of thickness in the (a) to (g) of Fig. 2 can be selected in accordance with the specifications of the electronic device. At this time, for example, by a configuration in which the volume of the high thermally conductive portion and also the area opposed to the face of the applied device are large, the amount of heat dissipation can be efficiently controlled, which is thus preferred.

### <High Thermally Conductive Portion>

The high thermally conductive portion is formed of a resin composition, being a base material having excellent flexibility. The shape of the above high thermally conductive portion is not particularly limited and can be appropriately changed according to the specifications of an electronic device or the like described later. Here, the high thermally conductive portion in the present invention refers to one having higher thermal conductivity than that of the low thermally conductive portion described later.

### (Resin)

The resin used in the present invention can be appropriately selected from those used in the field of electronic parts, and the like.

Examples of the resin include thermosetting resins, thermoplastic resins, and photocurable resins. Examples of the resin constituting the above high thermally conductive portion include polyolefin-based resins such as polyethylene and polypropylene; styrene-based resins such as polystyrene; acrylic resins such as polymethyl methacrylate; polyamide-based resins such as polyamides (nylon 6, nylon 66, and the like), poly(m-phenylene isophthalamide), and poly(p-phenylene terephthalamide); polyester-based resins such as polyethylene terephthalate, polybutylene terephthalate, polyethylene naphthalate, and polyarylates; cycloolefin-based polymers such as norbornene-based polymers, monocyclic cyclic olefin-based polymers, cyclic conjugated diene-based polymers, vinyl alicyclic hydrocarbon polymers, and hydrides thereof; vinyl chloride; polyimides; polyamideimides; polyphenylene ether; polyetherketones; polyetheretherketones; polycarbonates; polysulfone-based resins such as polysulfones and polyethersulfones; polyphenylene sulfide; silicone resins; and combinations of two or more of these polymers. Among these, polyamide-based resins, polyimides, polyamideimides, and silicone resins are preferred in that the heat resistance is excellent, and the heat dissipation properties are less likely to decrease.

The high thermally conductive portion is preferably formed of a resin composition comprising the above resin and a thermally conductive filler and/or an electrically conductive carbon compound in order to adjust to the desired thermal conductivity described later.

The thermally conductive filler and the electrically conductive carbon compound are sometimes referred to as "thermal conductivity adjustment substances" below.

### (Thermally Conductive Filler and Electrically Conductive Carbon Compound)

The thermally conductive filler is not particularly limited, but at least one selected from the group consisting of metal oxides such as silica, alumina, and magnesium oxide, metal nitrides such as silicon nitride, aluminum nitride, magnesium nitride, and boron nitride, and metals such as copper and aluminum is preferred. In addition, as the electrically conductive carbon compound, at least one selected from the group consisting of carbon black, carbon nanotubes (CNTs), graphene, carbon nanofibers, and the like is preferred. One of these thermally conductive fillers and electrically conductive carbon compounds can be used singly, or two or more of these thermally conductive fillers and electrically conductive carbon compounds can be used in combination. Among these, thermally conductive fillers are preferred as the thermal conductivity adjustment substance. In addition, a metal oxide and a metal nitride are more preferably contained as the thermally conductive fillers. Further, when a metal oxide and a metal nitride are contained as the thermally conductive fillers, the mass ratio of the metal oxide to the metal nitride is preferably 10:90 to 90:10, more preferably 20:80 to 80:20, and further preferably 50:50 to 75:25.

The shape of the thermal conductivity adjustment substance is not particularly limited, and may be any shape as long as the electrical properties and the like of a device, element, or the like are not impaired by the contact of the thermal conductivity adjustment substance or mechanical damage when the thermally conductive adhesive sheet is affixed to the applied electronic device, element, or the like. The shape may be, for example, any of a plate shape (including a scaly shape), a spherical shape, a needle shape, a rod shape, and a fibrous shape.

For the size of the thermal conductivity adjustment substance, from the viewpoint of uniformly dispersing the thermal conductivity adjustment substance in the thickness direction of the high thermally conductive portion to improve thermal conductivity, for example, the average particle diameter is preferably 0.1 to 200 µm, more preferably 1 to 100 µm, further preferably 5 to 50 µm, and particularly preferably 10 to 30 µm. The average particle diameter can be measured, for example, by the Coulter counter method. When the average particle diameter of the thermal conductivity adjustment substance is in this range, the thermal conduction inside the individual substances does not decrease, and as a result, the thermal conductivity of the high thermally conductive portion improves. In addition, the flocculation of particles is less likely to occur, and the thermal conductivity adjustment substance can be uniformly dispersed. Further, the filling density in the high thermally conductive portion is sufficient, and the high thermally conductive portion is not brittle at the substance interface.

The content of the thermal conductivity adjustment substance is appropriately adjusted according to the desired thermal conductivity and is preferably 40 to 99% by mass, more preferably 50 to 95% by mass, and particularly preferably 50 to 80% by mass in the resin composition. When the content of the thermal conductivity adjustment substance is in this range, the heat dissipation properties, folding resistance, and bending resistance are excellent, and the strength of the high thermally conductive portion is maintained.

### (Other Components)

For example, additives such as a photopolymerization initiator, a crosslinking agent, a filling agent, a plasticizer, an antioxidant, an oxidation inhibitor, an ultraviolet absorbing agent, a colorant such as a pigment or a dye, a tackifier, an antistatic agent, and a coupling agent may be contained in the high thermally conductive portion in appropriate ranges as required.

### <Low Thermally Conductive Portion>

The shape of the low thermally conductive portion is not particularly limited and can be appropriately changed according to the specifications of an electronic device or the like described later, like the shape of the above high thermally conductive portion. Here, the low thermally conductive portion of the present invention refers to one having lower thermal conductivity than that of the above high thermally conductive portion.

The low thermally conductive portion is not particularly limited as long as it is a material having lower thermal conductivity than that of the above high thermally conductive portion. The low thermally conductive portion is formed of a resin composition, a metal, or the like. Among them, the low thermally conductive portion is preferably formed of a resin composition (referred to as a resin composition in the present invention even when it does not comprise the thermal conductivity adjustment substance and the like described above) because a base material having excellent flexibility is obtained. The resin is not particularly limited. Examples of the resin include the same type of resin as the resin used in the high thermally conductive portion described above. Usually, the same resin as the resin used in the high thermally conductive portion is used from the viewpoint of mechanical properties, adhesiveness, and the like.

When the thermal conductivity is sufficiently lower than the thermal conductivity of the above high thermally conductive portion, the thermal conductivity adjustment substance may be contained in the resin composition, but no thermal conductivity adjustment substance is more preferably contained in order to increase the difference from the thermal conductivity of the above high thermally conductive portion.

### (Other Components)

The same types of additives may be further contained in the low thermally conductive portion in appropriate ranges as required, like the above high thermally conductive portion.

The thicknesses of the respective layers of the high thermally conductive portion and the low thermally conductive portion are preferably 1 to 200 µm, further preferably 3 to 100 µm. When the thicknesses are in this range, heat can be selectively dissipated in a particular direction. In addition, the thicknesses of the respective layers of the high thermally conductive portion and the low thermally conductive portion may be the same or different.

The widths of the respective layers of the high thermally conductive portion and the low thermally conductive portion are appropriately adjusted and used depending on the specifications of an applied electronic device and are usually 0.01 to 3 mm, preferably 0.1 to 2 mm, and further preferably 0.5 to 1.5 mm. When the widths are in this range, heat can be selectively dissipated in a particular direction. In addition, the widths of the respective layers of the high thermally conductive portion and the low thermally conductive portion may be the same or different.

The thermal conductivity of the high thermally conductive portion should be sufficiently higher than that of the low thermally conductive portion, and the thermal conductivity is preferably 0.5 (W/m·K) or more, more preferably 1.0 (W/m·K) or more, and further preferably 1.3 (W/m·K) or more. The upper limit of the thermal conductivity of the high thermally conductive portion is not particularly limited but is usually preferably 2000 (W/m·K) or less, more preferably 500 (W/m·K) or less.

The thermal conductivity of the low thermally conductive portion is preferably less than 0.5 (W/m·K), more preferably 0.3 (W/m·K) or less, and further preferably 0.25 (W/m·K) or less. When the respective thermal conductivities of the high thermally conductive portion and the low thermally conductive portion are in the ranges as described above, heat can be selectively dissipated in a particular direction.

The storage modulus of the high thermally conductive portion at 150°C is preferably 0.1 MPa or more, more preferably 0.15 MPa or more, and further preferably 1 MPa or more. In addition, the storage modulus of the low thermally conductive portion at 150°C is preferably 0.1 MPa or more, more preferably 0.15 MPa or more, and further preferably 1 MPa or more. When the storage moduli of the high thermally conductive portion and the low thermally conductive portion at 150°C are 0.1 MPa or more, excessive deformation of the base material is suppressed, and heat can be stably dissipated. The upper limit of the storage modulus of the high thermally conductive portion and the low thermally conductive portion at 150°C is not particularly limited but is preferably 500 MPa or less, more preferably 100 MPa or less, and further preferably 50 MPa or less.

The storage moduli of the high thermally conductive portion and the low thermally conductive portion at 150°C can be adjusted by the resin and the content of the thermal conductivity adjustment substance described above.

The storage modulus at 150°C is a value obtained by increasing the temperature to 150°C at a temperature increase rate of 3°C/min with an initial temperature of 15°C and measuring at a frequency of 11 Hz by a dynamic modulus measuring apparatus [manufactured by TA Instruments, model name "DMA Q800"].

Each of the arrangement of the high thermally conductive portion and the low thermally conductive portion and their shapes is not particularly limited as long as the target performance is not impaired.

On the face of the above base material opposite to the face in contact with the adhesive layer (that is, a case where the low thermally conductive portions and the high thermally conductive portions each independently constitute the entire thickness of the base material: Fig. 1 and Fig. 2(a)), the height difference between the high thermally conductive portions and the low thermally conductive portions is preferably 10 µm or less, more preferably 5 µm or less, and further preferably substantially absent.

In the cases in which at least either the high thermally conductive portions or the low thermally conductive portions constitute a portion of the thickness of the base material, for example, in the cases of Figs. 2(b) and 2(c), the height difference between the high thermally conductive portion(s) and the low thermally conductive portion(s) is preferably 10 µm or less, more preferably 5 µm or less, and further preferably substantially absent. Further, in the cases of Figs. 2(d) and 2(e) in which a predetermined height difference is provided between the high thermally conductive portion(s) and the low thermally conductive portion(s), the height difference between the high thermally conductive portion(s) and the low thermally conductive portion(s) when the thickness of the base material is defined as a thickness comprising the thicknesses of the high thermally conductive portion(s) and the low thermally conductive portion(s) is preferably 10 to 90% with respect to the thickness of the base material. In addition, in the base material, the volume ratio of the high thermally conductive portion(s) to the low thermally conductive portion(s) is preferably 10:90 to 90:10, more preferably 20:80 to 80:20, and further preferably 30:70 to 70:30.

### <Adhesive Layer>

Examples of the adhesive constituting the adhesive layer include known adhesives such as rubber-based adhesives, acrylic adhesives, urethane-based adhesives, silicone-based adhesives, olefin-based adhesives, and epoxy-based adhesives. Among these, silicone-based adhesives are preferably used from the viewpoint of excellent heat resistance, high thermal conductivity, and excellent heat dissipation properties.

For example, other components such as a tackifier, a plasticizer, a photopolymerizable compound, a photopolymerization initiator, a foaming agent, a polymerization inhibitor, an antioxidant, a filler, a coupling agent, and an antistatic agent may be added to the adhesive layer in a range in which the object of the present invention is not impaired.

The thickness of the adhesive layer is preferably 1 to 200 µm, further preferably 5 to 100 µm. In this range, in the case of use as the thermally conductive adhesive sheet, the control performance relating to heat dissipation is not influenced, and heat can be selectively dissipated in a particular direction.

From the viewpoint of adjusting the balance between control performance relating to heat dissipation and adhesion in the thermally conductive adhesive sheet, the ratio between the thickness of the above base material and the thickness of the above adhesive layer (the adhesive layer/the base material) is preferably 0.005 to 1.0, more preferably 0.01 to 0.8, and further preferably 0.1 to 0.5.

### <Release Sheet>

The thermally conductive adhesive sheet may have a release sheet on the surface of the adhesive layer. Examples of the release sheet include sheets obtained by applying release agents such as silicone resins and fluororesins to paper such as glassine paper, coated paper, and laminated paper and various plastic films. The thickness of the release sheet is not particularly limited but is usually 20 to 150 µm. As the supporting base material used in the release sheet used in the present invention, plastic films are preferably used.

### <Electronic Device>

The electronic device laminating the thermally conductive adhesive sheet of the present invention is not particularly limited. From the viewpoint of heat control such as heat dissipation, examples of the electronic device include thermoelectric conversion devices, photoelectric conversion devices, and semiconductor devices such as large scale integrated circuits. Particularly, by laminating the thermally conductive adhesive sheet on a thermoelectric conversion module, heat can be selectively dissipated in a particular direction, and as a result, the thermoelectric performance can be improved. Therefore, the thermally conductive adhesive sheet is preferably used in thermoelectric conversion devices.

The thermally conductive adhesive sheet may be laminated on one face of the electronic device or on both faces. This is appropriately selected in accordance with the specifications of the electronic device.

The electronic device will be described below by taking the case of a thermoelectric conversion device as an example.

### (Thermoelectric Conversion Device)

A thermoelectric conversion device is an electronic device in which power is easily obtained by providing a temperature difference to the inside of thermoelectric conversion elements that perform mutual energy conversion between heat and electricity.

Fig. 3 is a cross-sectional view showing one example of a thermoelectric conversion device in which the thermally conductive adhesive sheets of the present invention are laminated on a thermoelectric conversion module. A thermoelectric conversion device 10 shown in Fig. 3 is composed of a thermoelectric conversion module 16 which has on a support (not shown) thermoelectric conversion elements composed of thin film P-type thermoelectric elements 11 comprising a P-type material and thin film N-type thermoelectric elements 12 comprising an N-type material and further is provided with electrodes 13, a thermally conductive adhesive sheet 1A laminated on the first face 17 of the thermoelectric conversion module 16, and further a thermally conductive adhesive sheet 1B laminated on a second face 18 opposite to the above first face 17.

The thermally conductive adhesive sheet 1A comprises a base material comprising high thermally conductive portions 14a and 14b and low thermally conductive portions 15a, 15b, and 15c, and an adhesive layer 20 laminated on one face of the base material, and the thermally conductive adhesive sheet 1B comprises a base material comprising high thermally conductive portions 14'a, 14'b, and 14'c and low thermally conductive portions 15'a and 15'b, and an adhesive layer 20 laminated on one face of the base material.

Fig. 4 shows one example of a perspective view in which the thermally conductive adhesive sheets of the present invention and a thermoelectric conversion module are disassembled for each component. In Fig. 4, (a) is a perspective view of the thermally conductive adhesive sheet 1A provided on the thermoelectric elements on the front face side of the support 19 of the thermoelectric conversion module, (b) is a perspective view of the thermoelectric conversion module 16, and (c) is a perspective view of the thermally conductive adhesive sheet 1B provided on the back face side of the support 19 of the thermoelectric conversion module.

By the configuration as described above, heat can be efficiently diffused from the thermally conductive adhesive sheet 1A and the thermally conductive adhesive sheet 1B. In addition, by lamination in which the positions are displaced so that the high thermally conductive portions 14a and 14b of the thermally conductive adhesive sheet 1A are not opposed to the high thermally conductive portions 14'a, 14'b, and 14'c of the thermally conductive adhesive sheet 1B, heat can be selectively dissipated in a particular direction. Thus, a temperature difference can be efficiently provided to the thermoelectric conversion module, and a thermoelectric conversion device having high power generation efficiency is obtained.

The thermoelectric conversion module 16 used in the present invention is composed of the P-type thermoelectric elements 11, the N-type thermoelectric elements 12, and the electrodes 13, for example, on the support 19 as shown in Fig. 4(b). The P-type thermoelectric elements 11 and the N-type thermoelectric elements 12 are formed into a thin film shape in series connection, and they are joined and electrically connected at respective ends via the electrodes 13. The P-type thermoelectric elements 11 and the N-type thermoelectric elements 12 in the thermoelectric conversion module 16 may be arranged in order of "the electrode 13, the P-type thermoelectric element 11, the electrode 13, the N-type thermoelectric element 12, the electrode 13, ....." as shown in Fig. 3, in order of "the electrode 13, the P-type thermoelectric element 11, the N-type thermoelectric element 12, the electrode 13, the P-type thermoelectric element 11, the N-type thermoelectric element 12, the electrode 13, .....," or further in order of "the electrode 13, the P-type thermoelectric element 11, the N-type thermoelectric element 12, the P-type thermoelectric element 11, the N-type thermoelectric element 12, ... the electrode 13."

For the above thermoelectric elements, materials having a large absolute value of the Seebeck coefficient, low thermal conductivity, and high electrical conductivity, that is, so-called high thermoelectric figure of merit, in the temperature range of a source of heat converted to electrical energy by the thermoelectric conversion module are preferably used, though not particularly limited.

The materials constituting the P-type thermoelectric elements and the N-type thermoelectric elements are not particularly limited as long as they have thermoelectric conversion properties. Bismuth-tellurium-based thermoelectric semiconductor materials such as bismuth telluride and Bi₂Te₃, telluride-based thermoelectric semiconductor materials such as GeTe and PbTe, antimony-tellurium-based thermoelectric semiconductor material, zinc-antimony-based thermoelectric semiconductor materials such as ZnSb, Zn₃Sb₂, and Zn₄Sb₃, silicon-germanium-based thermoelectric semiconductor materials such as SiGe, bismuth selenide-based thermoelectric semiconductor materials such as Bi₂Se₃, silicide-based thermoelectric semiconductor materials such as β-FeSi₂, CrSi₂, MnSi_{1.73}, and Mg₂Si, oxide-based thermoelectric semiconductor materials, Heusler materials such as FeVAl, FeVAlSi, and FeVTiAl, and the like are used.

The thicknesses of the P-type thermoelectric elements 11 and the N-type thermoelectric elements 12 are preferably 0.1 to 100 µm, further preferably 1 to 50 µm.

The thicknesses of the P-type thermoelectric elements 11 and the N-type thermoelectric elements 12 are not particularly limited and may be the same or different.

### [Method for Producing Thermally Conductive Adhesive Sheet]

A method for producing a thermally conductive adhesive sheet according to the present invention is a method for producing a thermally conductive adhesive sheet composed of a base material comprising a high thermally conductive portion and a low thermally conductive portion, and an adhesive layer, wherein the adhesive layer is laminated on one face of the base material; and the other face of the base material is composed of the face of the low thermally conductive portion opposite to the face in contact with the adhesive layer and the face of the high thermally conductive portion opposite to the face in contact with the adhesive layer, or at least either the high thermally conductive portion or the low thermally conductive portion constitutes a portion of the thickness of the base material, the method comprising the steps of forming a base material, on a releasable supporting base material, of a high thermally conductive portion formed of a resin composition and a low thermally conductive portion formed of a resin composition; and laminating an adhesive layer on the base material.

### <Base Material Forming Step>

This step is the step of forming a base material comprising a high thermally conductive portion and a low thermally conductive portion on a releasable supporting base material.

### (Supporting Base Material)

As the releasable supporting base material, the same one as the release sheet on the surface of the adhesive layer of the thermally conductive adhesive sheet described above can be used. Examples of the releasable supporting base material include paper such as glassine paper, coated paper, and laminated paper and various plastic films. Among these, plastic films to which release agents such as silicone resins and fluororesins are applied are preferred.

For the method for applying the release agent, known methods can be used.

### <High Thermally Conductive Portion Forming Step>

This step is the step of forming a high thermally conductive portion. The high thermally conductive portion is formed on a supporting base material or on a supporting base material and on a low thermally conductive portion, using the resin composition. The method for applying the resin composition is not particularly limited, and, for example, the high thermally conductive portion should be formed by a known method such as a stencil printing, a dispenser, a screen printing method, a roll coating method, or a slot die.

The curing conditions when a thermosetting resin is used in the resin composition used in the present invention are appropriately adjusted depending on the composition used, but it is preferably 80°C to 150°C, and more preferably 90°C to 120°C. In addition, the curing can also be performed while pressure is applied as required.

In addition, when a photocurable resin is used, the photocurable resin can be cured with ultraviolet rays using, for example, a low pressure mercury lamp, a medium pressure mercury lamp, a high pressure mercury lamp, an ultrahigh pressure mercury lamp, a carbon arc lamp, a metal halide lamp, or a xenon lamp. The amount of light is usually 100 to 1500 mJ/cm².

### <Low Thermally Conductive Portion Forming Step>

This step is the step of forming a low thermally conductive portion. The low thermally conductive portion is formed on a supporting base material, or on a supporting base material and on the high thermally conductive portion, using the above described resin composition. The method for applying the adhesive resin composition is not particularly limited, and, for example, the low thermally conductive portion should be formed by a known method such as a stencil printing method, a dispenser, a screen printing method, a roll coating method, or a slot die, like forming the high thermally conductive portion. In addition, the curing method is also similar to the method for curing the high thermally conductive portion.

The order of the formation of the high thermally conductive portion and the low thermally conductive portion is not particularly limited. It may be appropriately selected depending on the pattern shape, the specifications of an electronic device, and the like.

### <Adhesive Layer Laminating Step>

This step is the step of laminating an adhesive layer on the base material obtained in the above base material forming step.

The formation of the adhesive layer can be performed by a known method. The adhesive layer may be directly formed on the above base material, or the adhesive layer may be formed by bonding the adhesive layer previously formed on a release sheet to the above base material to transfer the adhesive layer to the base material.

According to the producing method of the present invention, a thermally conductive adhesive sheet that can release heat, or selectively control the flow of heat in a particular direction, inside an electronic device or the like and has low cost can be produced by a simple method.

### Examples

Next, the present invention will be described in more detail by Examples, but the present invention is not limited in any way by these examples.

The thermal conductivity measurement and temperature difference evaluation of thermally conductive sheets fabricated in Examples and Comparative Examples and the evaluation of electronic devices were performed by the following methods.

### (a) Thermal Conductivity Measurement of Thermally Conductive Adhesive Sheet

The thermal conductivity was measured using a thermal conductivity measuring apparatus (manufactured by EKO, HC-110).

### (b) Temperature Measurement of High Thermally Conductive Portions and Low Thermally Conductive Portions

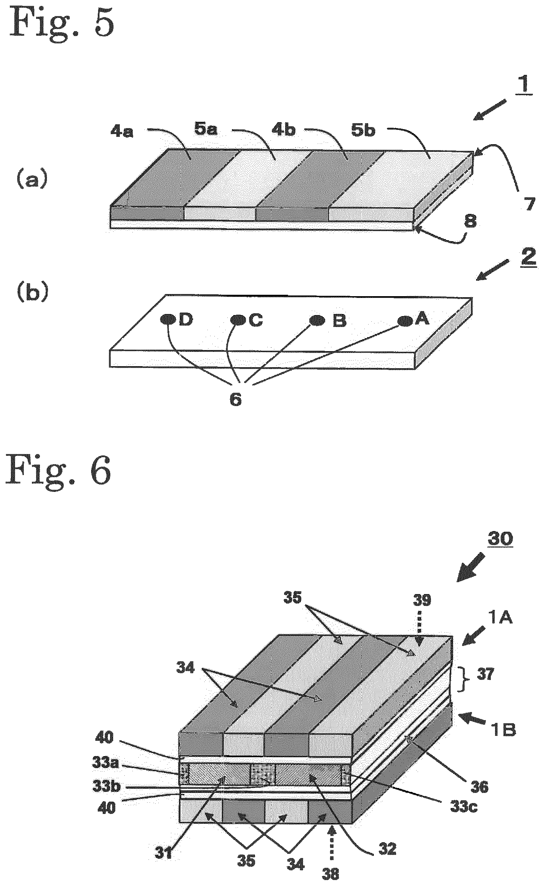

The release sheet of the obtained thermally conductive adhesive sheet was peeled, and the exposed adhesive layer was affixed to the upper face of an adherend 2 comprising soda glass (size 50 mm x 50 mm, thickness 0.5 mm) as shown in Fig. 5. Then, the releasable supporting base material on the other side was peeled. Then, the lower face of the adherend 2 was heated at 75°C for 1 hour to stabilize the temperature, and then the temperature of the adherend was measured by K thermocouples (Chromel-Alumel) attached to the upper face of the adherend 2. The thermocouples were provided on the adherend in portions corresponding to the high thermally conductive portions and the low thermally conductive portions (measurement places: A, B, C, and D in Fig. 5). The temperatures of the thermocouples were measured every second for 5 minutes, and the average value of the obtained temperatures at each point was calculated.

### (Fabrication of Thermoelectric Conversion Module)

As shown in part of Fig. 6, a P-type thermoelectric element 31 (P-type bismuth-tellurium-based thermoelectric semiconductor material) and an N-type thermoelectric element 32 (N-type bismuth-tellurium-based thermoelectric semiconductor material) were arranged on a support 36 so as to each have the same size (width 1.7 mm × length 100 mm, thickness 0.5 mm), and copper electrodes (copper electrode 33a: width 0.15 mm × length 100 mm, thickness 0.5 mm; copper electrode 33b: width 0.3 mm × length 100 mm, thickness 0.5 mm; and copper electrode 33c: width 0.15 mm × length 100 mm, thickness 0.5 mm) were provided on both thermoelectric elements and between the thermoelectric elements to fabricate a thermoelectric conversion module 37.

### (Electronic Device Evaluation)

In a state in which the lower face 38 of each of thermoelectric conversion devices obtained in Examples and Comparative Examples (see Fig. 6) was heated to 75°C on a hot plate, and the upper face 39 on the opposite side (see Fig. 6) was cooled to 25°C, the thermoelectric conversion device was held as it was for 1 hour to stabilize the temperature, and then the thermoelectromotive force V (V) and the electrical resistance R (Ω) were measured. The output P (W) was calculated by P = V²/R using the measured thermoelectromotive force V and electrical resistance R.

### (Example 1)

### (1) Fabrication of Thermally Conductive Adhesive Sheet

A solution containing a polyimide (manufactured by Nissan Chemical Industries, Ltd., SUNEVER 150) was diluted with N-methylpyrrolidone to prepare a 15% by mass solution. 40 Parts by mass of boron nitride (manufactured by Showa Denko K.K., "ALUNABEADS CB-A20S," average particle diameter 20 µm) and 20 parts by mass of alumina (manufactured by Showa Denko K.K., "SHOBN UHP-2," average particle diameter 12 µm) as thermally conductive fillers were added based on 100 parts by mass of the polyimide, and mixed and dispersed using a rotation-revolution mixer (manufactured by THINKY, "ARE-250") to prepare a resin composition for the formation of high thermally conductive portions.

On the other hand, a 15% by mass solution obtained by diluting a solution containing a polyimide (manufactured by Nissan Chemical Industries, Ltd., SUNEVER 150) with N-methylpyrrolidone was used as a resin composition for the formation of low thermally conductive portions.

Next, the above adhesive resin composition for the formation of high thermally conductive portions was applied to the release-treated face of a releasable supporting base material (manufactured by LINTEC Corporation, "SP-PET382150") using a dispenser (manufactured by Musashi engineering, "ML-808FXcom-CE") and dried at 90°C for 1 minute to remove the solvents to form high thermally conductive portions 34 comprising stripe-shaped patterns (width 1 mm x length 100 mm, thickness 50 µm, center distance between patterns 2 mm). Further, the adhesive resin composition for the formation of low thermally conductive portions was applied thereon using an applicator and dried at 120°C for 1 minute to form low thermally conductive portions 35 having the same thickness as that of the high thermally conductive portions between the stripe-shaped patterns of the high thermally conductive portions to obtain a base material. It was confirmed that the low thermally conductive portions 35 were not formed on the high thermally conductive portions 34. The absolute value of the difference between the thicknesses of the high thermally conductive portions 34 and the low thermally conductive portions 35 was 0 µm.

On the other hand, a silicone-based adhesive was applied to the release-treated face of a release sheet (manufactured by LINTEC Corporation) and dried at 90°C for 1 minute to form an adhesive layer 40 having a thickness of 10 µm.

The adhesive layer 40 was bonded to the base material to fabricate a thermally conductive adhesive sheet having the configuration shown in Fig. 2(a) sandwiched between the release sheet and the releasable supporting base material. On the face of the above base material opposite to the face in contact with the adhesive layer, the height difference between the high thermally conductive portions 34 and the low thermally conductive portions 35 was substantially absent.

The storage modulus of the high thermally conductive portions at 150°C was 4.2 MPa, and the storage modulus of the low thermally conductive portions at 150°C was 0.2 MPa.

### (2) Fabrication of Thermoelectric Conversion Device

The release sheets and the releasable supporting base materials were peeled and removed from two of the obtained thermally conductive adhesive sheets, and the thermally conductive adhesive sheets were laminated on the face of the thermoelectric conversion module 37 on the side on which the thermoelectric elements were formed and on the face on the support 36 side, respectively, as shown in Fig. 6 to fabricate a thermoelectric conversion device on both faces of which the thermally conductive adhesive sheets were laminated.

### (Example 2)

A thermally conductive adhesive sheet was fabricated as in Example 1 except that in the formation of high thermally conductive portions, a base material was fabricated using carbon nanotubes (manufactured by Nano-C, SWCNT), an electrically conductive carbon compound, as a thermal conductivity adjustment substance instead of boron nitride and alumina. A thermoelectric conversion device was fabricated as in Example 1 using the obtained thermally conductive adhesive sheet. The absolute value of the difference between the thicknesses of the high thermally conductive portions and the low thermally conductive portions was 0 µm. In addition, on the face of the above base material opposite to the face in contact with the adhesive layer, the height difference between the high thermally conductive portions and the low thermally conductive portions was substantially absent.

The storage modulus of the high thermally conductive portions at 150°C was 4.0 MPa, and the storage modulus of the low thermally conductive portions at 150°C was 0.2 MPa.

### (Example 3)

High thermally conductive portions comprising stripe-shaped patterns (width 1 mm x length 100 mm, thickness 50 µm, center distance between patterns 2 mm) were formed on the release-treated face of a releasable supporting base material as in Example 1 using the resin composition for the formation of the above high thermally conductive portions used in Example 1.

Then, the resin composition for the formation of low thermally conductive portions used in Example 1 was applied thereon and dried at 120°C for 1 minute to form a low thermally conductive portion having a thickness of 75 µm to fabricate a base material. The thermally conductive adhesive sheet had a configuration in which the low thermally conductive portion having a thickness of 75 µm was formed between the stripe-shaped patterns of the high thermally conductive portions and on the high thermally conductive portions, and a low thermally conductive portion having a thickness of 25 µm was formed on the high thermally conductive portions. The absolute value of the difference between the thicknesses of the high thermally conductive portions and the low thermally conductive portion was 25 µm. Further, an adhesive layer was laminated as in Example 1 to fabricate a thermally conductive adhesive sheet having the configuration shown in Fig. 2(c). In addition, on the face of the above base material opposite to the face in contact with the adhesive layer, the height difference between the high thermally conductive portions and the low thermally conductive portion was substantially absent.

A thermoelectric conversion device was fabricated as in Example 1 using the obtained thermally conductive adhesive sheet.

### (Example 4)

The releasable supporting base material was peeled from the base material obtained in Example 3, and the exposed face was bonded to an adhesive layer to fabricate a thermally conductive adhesive sheet having the configuration shown in Fig. 2(f). The face of the base material of the obtained thermally conductive adhesive sheet opposite to the face in contact with the adhesive layer was entirely composed of the low thermally conductive portion. A thermoelectric conversion device was fabricated as in Example 1 using the obtained thermally conductive adhesive sheet.

### (Example 5)

A thermally conductive adhesive sheet having the configuration shown in Fig. 2(b) was fabricated as in Example 3 except that the configuration of the high thermally conductive portions and the low thermally conductive portion in the base material was reversed, that is, the high thermally conductive portions were changed to low thermally conductive portions and the low thermally conductive portion was changed to a high thermally conductive portion. A thermoelectric conversion device was fabricated as in Example 1 using the obtained thermally conductive adhesive sheet.

### (Example 6)

A thermally conductive adhesive sheet having the configuration shown in Fig. 2(g) was fabricated as in Example 4 except that the configuration of the high thermally conductive portions and the low thermally conductive portion in the base material was reversed. A thermoelectric conversion device was fabricated as in Example 1 using the obtained thermally conductive adhesive sheet.

### (Example 7)

High thermally conductive portions were formed in stripe-shaped patterns (width 1 mm × length 100 mm, thickness 50 µm, center distance between patterns 2 mm) on the release-treated face of a releasable supporting base material as in Example 1 using the above resin composition for the formation of high thermally conductive portions used in Example 1.

Then, the above resin composition for the formation of low thermally conductive portions used in Example 1 was applied on the release-treated face of a releasable supporting base material and dried at 120°C for 1 minute to form a low thermally conductive portion having a thickness of 25 µm.

Then, the low thermally conductive portion was bonded to the high thermally conductive portions to fabricate a base material. The obtained base material had a configuration in which the high thermally conductive portions in stripe-shaped patterns having a thickness of 50 µm were laminated on the low thermally conductive portion having a thickness of 25 µm. Further, the adhesive layer used in Example 1 was laminated on the opposite face of the low thermally conductive portion not having the stripe-shaped patterns to fabricate a thermally conductive adhesive sheet having the configuration shown in Fig. 2(e). A thermoelectric conversion device was fabricated as in Example 1 using the obtained thermally conductive adhesive sheet.

### (Example 8)

A thermally conductive adhesive sheet having the configuration shown in Fig. 2(d) was fabricated as in Example 7 except that the configuration of the high thermally conductive portions and the low thermally conductive portion in the base material was reversed. A thermoelectric conversion device was fabricated as in Example 1 using the obtained thermally conductive adhesive sheet.

### (Comparative Example 1)

An adhesive layer was laminated as in Example 1 using a PGS graphite sheet (manufactured by Panasonic Devices, thermal conductivity: 1950 (W/m·K), thickness: 100 µm) as a base material to fabricate a thermally conductive adhesive sheet. A thermoelectric conversion device was fabricated as in Example 1 using the obtained thermally conductive adhesive sheet.

### (Comparative Example 2)

The measurement of the temperature difference was performed without affixing a thermally conductive adhesive sheet to an adherend. In addition, electronic device evaluation was performed without laminating thermally conductive adhesive sheets on the thermoelectric conversion module 37.

The evaluation results of the thermoelectric conversion devices obtained in Examples 1 to 8 and Comparative Examples 1 and 2 are shown in Table 1.

**Table 1**

| | Configuration of thermally conductive adhesive sheet | Thickness of adhesive layer (µm) | Thickness of base material (µm) | Ratio of thickness (adhesive layer/ base material) | Thickness of high thermally conductive portion(s) (µm) | Thickness of low thermally conductive portion(s) (µm) | Thermal conductivity adjustment substance in high thermally conductive portion(s) | Thermal conductivity (W/m·K) | | Temperature difference evaluation temperature (°C) | | | | Electronic device evaluation output (mW) |
|---|---|---|---|---|---|---|---|---|---|---|---|---|---|---|
| | | | | | | | | High thermally conductive portion(s) | Low thermally conductive portion(s) | A | B | C | D | |
| Example 1 | Fig. 2(a) | 10 | 50 | 0.20 | 50 | 50 | Boron nitride, alumina | 1.8 | 0.2 | 25 | 60 | 25 | 65 | 19.6 |
| Example 2 | Fig. 2(a) | 10 | 50 | 0.20 | 50 | 50 | Carbon nanotubes | 1.5 | 0.2 | 25 | 55 | 25 | 55 | 14.4 |
| Example 3 | Fig. 2(c) | 10 | 75 | 0.13 | 50 | 75 | Boron nitride, alumina | 1.8 | 0.2 | 25 | 40 | 25 | 40 | 3.6 |
| Example 4 | Fig. 2(f) | 10 | 75 | 0.13 | 50 | 75 | Boron nitride, alumina | 1.8 | 0.2 | 25 | 45 | 25 | 45 | 6.4 |
| Example 5 | Fig. 2(b) | 10 | 75 | 0.13 | 50 | 25 | Boron nitride, alumina | 1.8 | 0.2 | 65 | 40 | 65 | 40 | 12.3 |
| Example 6 | Fig. 2(g) | 10 | 75 | 0.13 | 50 | 25 | Boron nitride, alumina | 1.8 | 0.2 | 65 | 55 | 65 | 55 | 2.4 |
| Example 7 | Fig. 2(e) | 10 | 75 | 0.13 | 50 | 25 | Boron nitride, alumina | 1.8 | 0.2 | 43 | 25 | 43 | 25 | 5.0 |
| Example 8 | Fig. 2(d) | 10 | 75 | 0.13 | 25 | 50 | Boron nitride, alumina | 1.8 | 0.2 | 65 | 60 | 65 | 60 | 1.2 |
| Comparative Example 1 | Graphite sheet | 10 | 100 | 0.1 | [100] | - | - | 1950 | | 25 | 25 | 25 | 25 | 0 |
| Comparative Example 2 | None | - | - | - | - | - | - | - | | 75 | 75 | 75 | 75 | 0 |

It was found that in the thermally conductive adhesive sheets of the present invention used in Examples 1 to 8, compared with the Comparative Examples, the temperature difference between the high thermally conductive portions and the adjacent low thermally conductive portions was large. In addition, it was found that when the thermally conductive adhesive sheets of the present invention were applied to thermoelectric conversion devices, large output was obtained.

### Industrial Applicability

Particularly when the thermally conductive adhesive sheet of the present invention is affixed to the thermoelectric conversion module of a thermoelectric conversion device, one of electronic devices, a temperature difference can be efficiently provided in the thickness direction of the thermoelectric elements, and therefore power generation with high power generation efficiency is possible, and the number of installed thermoelectric conversion modules can be decreased compared with conventional types, leading to downsizing and cost reduction. In addition, at the same time, by using the thermally conductive adhesive sheet of the present invention, a flexible type thermoelectric conversion device can be used without the installation place being limited; for example, it is installed in a waste heat source or a heat dissipation source having an uneven face.

### Reference Signs List

1, 1A, 1B: thermally conductive adhesive sheet
2: adherend
4, 4a, 4b: high thermally conductive portion
5, 5a, 5b: low thermally conductive portion
6: temperature difference measurement portion
7: base material
8: adhesive layer
10: thermoelectric conversion device
11: P-type thermoelectric element
12: N-type thermoelectric element
13: electrode (copper)
14a, 14b: high thermally conductive portion
14'a, 14'b, 14'c: high thermally conductive portion
15a, 15b, 15c: low thermally conductive portion
15'a, 15'b: low thermally conductive portion
16: thermoelectric conversion module
17: first face of 16
18: second face of 16
19: support
20: adhesive layer
30: thermoelectric conversion device
31: P-type thermoelectric element
32: N-type thermoelectric element
33a, 33b, 33c: electrode (copper)
34: high thermally conductive portion
35: low thermally conductive portion
36: support
37: thermoelectric conversion module
38: lower face of thermoelectric conversion device 30
39: upper face of thermoelectric conversion device 30
40: adhesive layer
41: P-type thermoelectric element
42: N-type thermoelectric element
43: electrode (copper)
44: film-shaped substrate
45: film-shaped substrate
46: thermoelectric conversion module
47, 48: material having low thermal conductivity (polyimide)
49, 50: material having high thermal conductivity (copper)
51, 52: low thermal conductivity member
53: thermoelectric element
54: electrode (copper)
55: electrically conductive adhesive layer
56: insulating adhesive layer

## Claims

1. A thermally conductive adhesive sheet (1, 1A, 1B) comprising:
a base material (7) comprising a high thermally conductive portion (4, 4a, 4b) and a low thermally conductive portion (5, 5a, 5b), and
an adhesive layer (8),
wherein the adhesive layer is laminated on one face of the base material; and the other face of the base material is composed of a face of the low thermally conductive portion opposite to a face in contact with the adhesive layer and a face of the high thermally conductive portion opposite to a face in contact with the adhesive layer, or at least either the high thermally conductive portion or the low thermally conductive portion constitutes a portion of a thickness of the base material,
**characterized in that** the high thermally conductive portion and the low thermally conductive portion are each formed of a resin composition, and **in that**
the resin composition constituting the high thermally conductive portion comprises a thermally conductive filler and/or an electrically conductive carbon compound.

2. The thermally conductive adhesive sheet according to claim 1, wherein the high thermally conductive portion and the low thermally conductive portion each independently constitute an entire thickness of the base material.

3. The thermally conductive adhesive sheet according to claim 1, wherein the resin of the high thermally conductive portion is polyamide-based resins, polyimides, or polyamideimides.

4. The thermally conductive adhesive sheet according to claim 1, wherein the thermally conductive filler comprises at least one selected from the group consisting of a metal oxide, a metal nitride, and a metal.

5. The thermally conductive adhesive sheet according to claim 1, wherein the thermally conductive filler comprises a metal oxide and a metal nitride.

6. The thermally conductive adhesive sheet according to claim 1, wherein the electrically conductive carbon compound comprises at least one selected from the group consisting of carbon black, carbon nanotubes, graphene, and carbon nanofibers.

7. The thermally conductive adhesive sheet according to claim 1, wherein a thermal conductivity of the high thermally conductive portion of the base material is 1.0 (W/m·K) or more, and a thermal conductivity of the low thermally conductive portion is less than 0.5 (W/m.K).

8. The thermally conductive adhesive sheet according to claim 1, wherein a ratio of a thickness of the adhesive layer to the thickness of the base material (the adhesive layer/the base material) is 0.005 to 1.0.

9. The thermally conductive adhesive sheet according to claim 1, wherein the adhesive layer comprises a silicone-based adhesive.

10. An electronic device (19, 30) on which the thermally conductive adhesive sheet (1, 1A, 1B) according to claim 1 is laminated.

11. A method for producing the thermally conductive adhesive sheet (1, 1A, 1B) according to claim 1, comprising steps of forming a base material (7), on a releasable supporting base material, of a high thermally conductive portion (4, 4a, 4b) formed of a resin composition and a low thermally conductive portion (5, 5a, 5b) formed of a resin composition; and laminating an adhesive layer (8) on the base material.

## Patentansprüche

1. Wärmeleitende Klebefolie (1, 1A, 1B), umfassend:
ein Basismaterial (7), umfassend einen hoch wärmeleitenden Teil (4, 4a, 4b) und einen gering wärmeleitenden Teil (5, 5a, 5b), und
eine Klebeschicht (8),
wobei die Klebeschicht auf eine Seite des Basismaterials laminiert ist; und die andere Seite des Basismaterials besteht aus einer Fläche des gering wärmeleitenden Teils gegenüber einer Fläche in Kontakt mit der Klebeschicht und einer Fläche des hoch wärmeleitenden Teils gegenüber einer Fläche in Kontakt mit der Klebeschicht, oder zumindest entweder der hoch wärmeleitende Teil oder der gering wärmeleitende Teil bildet einen Teil einer Dicke des Basismaterials,
**gekennzeichnet dadurch, dass** der hoch wärmeleitende Teil und der gering wärmeleitende Teil jeweils aus einer Harzzusammensetzung gebildet sind, und dadurch dass die Harzzusammensetzung, die den hoch wärmeleitenden Teil bildet, einen wärmeleitenden Füllstoff und / oder eine elektrisch leitfähige Kohlenstoffverbindung umfasst.

2. Wärmeleitende Klebefolie nach Anspruch 1, wobei der hoch wärmeleitende Teil und der gering wärmeleitende Teil jeweils unabhängig eine Gesamtdicke des Basismaterials bilden.

3. Wärmeleitende Klebefolie nach Anspruch 1, wobei das Harz des hoch wärmeleitenden Teils Harze auf Polyamid-Basis, Polyimiden oder Polyamidimide sind.

4. Wärmeleitende Klebefolie nach Anspruch 1, wobei der wärmeleitende Füllstoff mindestens eines umfasst, ausgewählt aus der Gruppe bestehend aus einem Metalloxid, einem Metallnitrid und einem Metall.

5. Wärmeleitende Klebefolie nach Anspruch 1, wobei der wärmeleitende Füllstoff ein Metalloxid und ein Metallnitrid umfasst.

6. Wärmeleitende Klebefolie nach Anspruch 1, wobei die elektrisch leitfähige Kohlenstoffverbindung mindestens eines ausgewählt aus der Gruppe bestehend aus Ruß, Kohlenstoff-Nanoröhrchen, Graphen und Kohlenstoff-Nanofasern umfasst.

7. Wärmeleitende Klebefolie nach Anspruch 1, wobei eine Wärmeleitfähigkeit des hoch wärmeleitenden Teils des Basismaterials 1,0 (W/m·K) oder mehr beträgt und eine Wärmeleitfähigkeit des gering wärmeleitenden Teils weniger als 0,5 (W/m·K) beträgt.

8. Wärmeleitende Klebefolie nach Anspruch 1, wobei ein Verhältnis einer Dicke der Klebeschicht zu der Dicke des Basismaterials (Klebeschicht / Basismaterial) 0,005 bis 1,0 beträgt.

9. Wärmeleitende Klebefolie nach Anspruch 1, wobei die Klebeschicht einen Klebstoff auf Silikonbasis umfasst.

10. Elektronisches Gerät (19, 30), auf das die wärmeleitende Klebefolie (1, 1A, 1B) nach Anspruch 1 laminiert ist.

11. Verfahren zur Herstellung der wärmeleitenden Klebefolie (1, 1A, 1B) nach Anspruch 1, umfassend die Schritte des Bildens eines Basismaterials (7) auf einem ablösbaren Trägerbasismaterial aus einem hoch wärmeleitenden Teil (4, 4a, 4b), der aus einer Harzzusammensetzung und einem gering wärmeleitenden Teil (5, 5a, 5b), der aus einer Harzzusammensetzung gebildet ist; und Laminieren einer Klebeschicht (8) auf das Basismaterial.

## Revendications

1. Feuille adhésive thermoconductrice (1, 1A, 1B) comprenant :
un matériau de base (7) comprenant une partie hautement thermoconductrice (4, 4a, 4b) et une partie faiblement thermoconductrice (5, 5a, 5b), et
une couche adhésive (8),
dans laquelle la couche adhésive est stratifiée sur une face du matériau de base ; et l'autre face du matériau de base est composée d'une face de la partie faiblement thermoconductrice opposée à une face en contact avec la couche adhésive et d'une face de la partie hautement thermoconductrice opposée à une face en contact avec la couche adhésive, ou au moins la partie hautement thermoconductrice ou la partie faiblement thermoconductrice constitue une partie de l'épaisseur du matériau de base,
**caractérisée en ce que** la partie hautement thermoconductrice et la partie faiblement thermoconductrice sont constituées chacune d'une composition de résine, et **en ce que**
la composition de résine constituant la partie hautement thermoconductrice comprend une charge thermoconductrice et/ou un composé carboné électroconducteur.

2. Feuille adhésive thermoconductrice selon la revendication 1, dans laquelle la partie hautement thermoconductrice et la partie faiblement thermoconductrice constituent chacune indépendamment toute l'épaisseur du matériau de base.

3. Feuille adhésive thermoconductrice selon la revendication 1, dans laquelle la résine de la partie hautement thermoconductrice est une résine à base de polyamide, un polyimide ou un polyamideimide.

4. Feuille adhésive thermoconductrice selon la revendication 1, dans laquelle la charge thermoconductrice comprend au moins un élément choisi dans le groupe constitué par un oxyde métallique, un nitrure métallique et un métal.

5. Feuille adhésive thermoconductrice selon la revendication 1, dans laquelle la charge thermoconductrice comprend un oxyde métallique et un nitrure métallique.

6. Feuille adhésive thermoconductrice selon la revendication 1, dans laquelle le composé carboné électroconducteur comprend au moins un élément choisi dans le groupe constitué par le noir de carbone, des nanotubes de carbone, le graphène et des nanofibres de carbone.

7. Feuille adhésive thermoconductrice selon la revendication 1, dans laquelle une conductivité thermique de la partie hautement thermoconductrice du matériau de base est supérieure ou égale à 1 (W/m.K), et une conductivité thermique de la partie faiblement thermoconductrice est inférieure à 0,5 (W/m.K).

8. Feuille adhésive thermoconductrice selon la revendication 1, dans laquelle le rapport de l'épaisseur de la couche adhésive sur l'épaisseur du matériau de base (la couche adhésive/le matériau de base) est de 0,005 à 1,0.

9. Feuille adhésive thermoconductrice selon la revendication 1, dans laquelle la couche adhésive comprend un adhésif à base de silicone.

10. Dispositif électronique (19, 30) sur lequel la feuille adhésive thermoconductrice (1, 1A, 1B) selon la revendication 1 est stratifiée.

11. Procédé de production de la feuille adhésive thermoconductrice (1, 1A, 1B) selon la revendication 1, comprenant des étapes consistant à former un matériau de base (7), sur un matériau de base de support amovible, d'une partie hautement thermoconductrice (4, 4a, 4b) formée d'une composition de résine et d'une partie faiblement thermoconductrice (5, 54, 5b) formée d'une composition de résine ; et à stratifier une couche adhésive (8) sur le matériau de base.
